# EUROPÄISCHE PATENTSCHRIFT

(11) **EP 0 432 713 B1**
(45) Veröffentlichungstag und Bekanntmachung des Hinweises auf die Patenterteilung: **01.04.1998**
(21) Anmeldenummer: 90123763.6
(22) Anmeldetag: 11.12.1990
(51) Int. Cl.: G03F 7/34, G03F 3/10

(54) **Verfahren zur Herstellung von Bildern auf tonbaren lichtempfindlichen Schichten**
Process for the preparation of images on tonable light-sensitive layers
Procédé pour la préparation d'images sur des couches pigmentables et photosensibles

(30) Priorität: 15.12.1989 DE 3941446
(43) Veröffentlichungstag der Anmeldung: 19.06.1991
(73) Patentinhaber: E.I. DU PONT DE NEMOURS AND COMPANY, Wilmington Delaware 19898 (US)
(72) Erfinder: Fröhlich, Helmut Dr., W-6056 Heusenstamm 2 (DE); Fryd, Michael, New Jersey 08057 (US)
(74) Vertreter: Pistor, Wolfgang, Dr. Dipl.-Chem.

(56) Entgegenhaltungen:
- EP-A- 0 255 032

## Beschreibung

Gegenstand der vorliegenden Anmeldung ist ein Verfahren zur Herstellung von Bildern auf tonbaren lichtempfindlichen Schichten.

Auf dem photographischen Reproduktionssektor werden lichtempfindliche Aufzeichnungsmaterialien verwendet, bei denen zur Bilderzeugung Unterschiede in der Klebrigkeit der belichteten und unbelichteten Bereiche der lichtempfindlichen Schicht ausgenutzt werden. So ist z.B. aus den deutschen Patentschriften 12 10 321, 19 04 058, 19 04 059 und 20 04 214 ein Reproduktionsverfahren bekannt, bei dem ein klebriges photopolymerisierbares Aufzeichnungsmaterial, bestehend aus einem Schichtträger und einer photopolymerisierbaren Schicht, die mindestens ein additionspolymerisierbares Monomeres und einen polymerisationsinitiator enthält, durch bildmässige Belichtung gehärtet wird, wobei die belichteten Bildteile ihre Klebrigkeit verlieren. Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden. Das Verfahren hat daher insbesondere in der Druckindustrie zur Prüfung von Farbauszügen erhebliche praktische Bedeutung erlangt.

Das Aufbringen der überwiegend aus feinteiligen Pulvern bestehenden Tonermaterialien kann durch Bestäuben der bildmässig belichteten Oberfläche mit dem Toner erfolgen. Nach einer anderen Ausführungsform kann sich der Toner auch lose gebunden auf einem gesonderten Träger befinden und durch in Kontaktbringen dieses Trägers mit der bildmässig belichteten Schicht übertragen werden.

So ist es z.B. aus der DE-PS 12 05 117 bekannt, für thermische übertragungsverfahren auf einen Schichtträger aufgebrachte, aus dem Tonermaterial und ggf. einem Bindemittel bestehende Schichten zu verwenden.

Aus der DE-PS 29 49 462 sind pigmentierte Schichten zur Herstellung von farbigen Bildern bekannt, die 75 - 95 Gew.-Teile Pigment und 25 - 5 Gew.-Teile eines elastomeren Bindemittels enthalten. Nach diesem Verfahren erhält man Bilder hoher Opazität, die bevorzugt zur Wiedergabe von Schriften und Schaustücken verwendet werden. Infolge der hohen Opazität ist das Verfahren jedoch nicht für Farbprüfverfahren geeignet. Eine drastische Herabsetzung des Pigmentgehaltes führt zwar zu einer verringerten Dichte, bewirkt aber den totalen Verlust der Auflösung.

In der Reproduktionstechnik werden bekanntlich gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft ob das spätere Druckergebnis eine tonwertrichtige Reproduktion der Vorlage darstellt.
Nach allgemeinen Standardvorschriften wird z.B. für einen hochwertigen Offsetdruck eine Auflösung von 2% - 98%- Punkten bei einer Rasterweite von 60 Linien/cm gefordert, wobei es besonders schwierig ist, eine befriedigende Auflösung der spitzen 2% Punkte in den Lichtern und der 98% Punkte in den Schatten zu erreichen. Für eine gute Tonwertwiedergabe ist es ferner von erheblicher Bedeutung, dass Rasterpunkte gleicher Grösse über den gesamten Flächenbereich scharf begrenzt und gleichmässig, d.h. ohne Schwankungen in der Grösse wiedergegeben werden.

Zwar ist es mit den in der DE-PS 36 25 014 beschriebenen Übertragungsmaterialien, deren wesentliches Merkmal ein spezielles Bindemittelsystem inkompatibler Polymere ist, möglich, diesen Anforderungen weitgehend zu genügen, jedoch weisen diese Übertragungsmaterialien noch Mängel und Nachteile auf, insbesondere was ihre Herstellung betrifft.

Ihr Herstellungsprozeß ist zeit- und kostenintensiv, und ein kontrollierbarer Schichtaufbau ist nur schwer zu erzielen. Voraussetzung ist immer die Herstellung und Lagerung zweier verschiedener, inkompatibler Polymere. Weiterhin ist es nachteilig, daß die Pigmente getrennt gemahlen werden müssen, daß die Produktionsansätze sofort weiterverarbeitet werden müssen und daß während des gesamten Herstellungsprozesses für eine intensive Durchnischung der Dispersionen gesorgt werden muß, um Absetzen und Verklumpen der Bestandteile zu vermeiden. Nur so kann ein einheitlicher Auftrag auf das Trägermaterial gewährleistet werden. Auch muß die Auftragsgeschwindigkeit niedrig sein, wodurch der Produktionsprozeß zusätzlich nachteilig beeinflußt wird.

Aufgabe der vorliegenden Erfindung ist es daher, ein Verfahren zur Herstellung von Bildern auf tonbaren lichtempfindlichen Schichten unter Verwendung einer mindestens ein feinteiliges Pulver und/oder einen gelösten Farbstoff enthaltenden Übertragungsschicht anzugeben, mit dem die von der Druckindustrie geforderte Auflösung erreicht werden kann, das sich ferner durch eine hohe Gleichmässigkeit der Rastertonwerte über die gesamte Fläche auszeichnet und das die im Vorhergehenden beschriebenen Nachteile und Mängel vermeidet. Diese Aufgabe wird gelöst durch die Verwendung einer Übertragungsschicht gemäß dem kennzeichnenden Teil von Anspruch 1.

Die Erfindung geht aus von einem Verfahren zur Herstellung von Bildern bei dem
a) auf einer lichtempfindlichen Schicht durch bildmäßige Belichtung klebrige und nicht-klebrige Bereiche erzeugt werden,
b) die belichtete Schicht mit einer auf einem Schichtträger befindlichen Übertragungsschicht, die nicht lichtempfindlich ist und mindestens ein feinteiliges Pulver und/oder einen gelösten Farbstoff in ihrem Bindemittel enthält, in Kontakt gebracht wird, und
c) die beiden Schichten getrennt werden,
wobei die Übertragungsschicht nur an den klebrigen Bildbereichen haften bleibt.

Die Erfindung ist dadurch gekennzeichnet, daß das Bindemittel der Übertragungsschicht mindestens ein core/shell Polymer, bestehend aus einen Kern und eine Hülle aufweisenden Teilchen, enthält, wobei
a) der Kern 5 - 95 Gew.-% eines Teilchens ausmacht und aus einem Polymer mit einer Glasübergangstemperatur von über 50° C besteht und
b) die Hülle 5 - 95 Gew.-% eines Teilchens ausmacht und aus einem Polymer mit einer Glasübergangstemperatur von unter 40° C besteht.

Core/shell-Polymere sind allgemein aus der Literatur bekannt. Auch ihre Verwendung als Bindemittelzusatz, Füller oder Mattierungsmittel in photopolymerisierbaren Materialien ist beschrieben, z.B. in der EP-A3 02 30 936. Diese europäische Patentanmeldung beschreibt die Verwendung von quellbaren Mikrogelen mit Glasübergangstemperaturen von über 25° C zur Viskositätssteigerung und zur Verbesserung der Lagerstabilität von photopolymerisierbaren Materialien, als Beispiel werden u.a. auch core/shell-Polymere genannt. Die Verwendung spezieller core/shell-Polymere zur Herstellung pigmentierter Übertragungsschichten wird durch EP 02 30 936 nicht nahegelegt.

In der EP 01 07 378 werden Schutzschichten für photographische Materialien beschrieben, die aus einer Polymerschicht aus einer Latexmasse, bestehend aus core/shell-Polymeren mit 80 bis 95 Gew.-% eines Kernpolymeren mit einer Glasübergangstemperatur von über 70° C und 5 - 20 Gew.-% eines Hüllenpolymeren mit einer Glasübergangstemperatur von 25 - 60° C, aufgebaut sind. Bei der vorliegenden Aufgabe sind die Angaben der EP 01 07 378 für die Auswahl der core/shell-Polymere nicht hilfreich. Sie unterstützen vielmehr das Vorurteil, daß die erfindungsgemäßen core/shell-Polymere zur Herstellung bildmäßig übertragbarer, pigmentierter Schichten nicht geeignet seien.

Wie aus der DE-PS 29 49 462 bekannt ist, müssen zwar pigmentierte Übertragungsmaterialien brüchig genug sein, um während der Übertragung bildmäßig zu brechen, so daß nach dem Entfernen der Schicht nur die klebrigen Bildbereiche des Aufzeichnungsmaterials durch die an ihnen haftende Schicht gefärbt sind. Die pigmentierten Übertragungsschichten dürfen aber andererseits nicht zu empfindlich sein oder Risse aufweisen, da sonst ihre Handhabbarkeit nicht gewährleistet und keine fehlerfreie Bildwiedergabe möglich ist.

Gegen die Verwendung der erfindungsgemäßen Polymere sprechen in dieser Hinsicht die Ergebnisse des Beispiels 5 der EP 01 07 378. Die dort beschriebenen core/shell-Polymere mit einer 40 Gew.-%igen Hülle bzw. einer Hülle mit einer Glasübergangstemperatur von 9° C bilden empfindliche, Risse aufweisende Schichten, schon wenn sie für sich allein vergossen werden. Die erfindungsgemäßen Übertragungsschichten müssen aber noch zusätzlich ein Pigment enthalten, so daß die dungswesentlichen core/shell-Polymere zu empfindliche Schichten ergeben sollten, die nicht mehr fehlerfrei handhabbar sind.

Überraschenderweise liefern aber core/shell-Polymere mit 5 - 95 Gew.-% eines Kernpolymeren mit einer Glasübergangstemperatur von über 50° C und 5 - 95 Gew.-% eines Hüllenpolymeren mit einer Glasübergangstemperatur von unter 40° C pigmentierte Übertragungsmaterialien hervorragender Qualität.

Die im erfindungsgemäßen Verfahren verwendeten Polymere werden üblicherweise in zwei Stufen nach der Methode der Emulsionspolymerisation hergestellt. Im ersten Schritt wird das Monomer oder die Monomermischung, aus dem oder denen der Kern aufgebaut werden soll, zu einer Lösung des Polymerisationskatalysators und Netzmitteln bei 80° C gegeben. Die Reaktion wird bis zur vollständigen Polymerisation fortgeführt. Dann wird das Monomer oder die Monomermischung für die Polymerisation der Hülle und neuer Initiator zugegeben und erneut polymerisiert. Die so erhaltenen core/shell-Polymere bestehen aus 5 - 95 Gew.-%, bevorzugt 40 - 95 Gew.-%, eines Kernpolymeren mit einer Glasübergangstemperatur von über 50° C, bevorzugt über 90° C, und aus 5 - 95 Gew.-%, bevorzugt 5 - 60 Gew.-%, eines Hüllenpolymeren mit einer Glasübergangstemperatur von unter 40° C, bevorzugt unter 20° C. Besonders bevorzugt sind solche Polymere mit einer relativ dünnen Hülle, 5 - 15 Gew.-%, aus Polymeren mit einer Glasübergangstemperatur zwischen -20° C und 0° C. Bei der Verwendung von Hüllenpolymeren mit höheren Glasübergangstemperaturen, 20° C bis 40° C, muß die Dicke der Hülle gegenüber dem Kern stark zunehmen, bevorzugt werden in diesen Fällen 50 - 95 Gew.-% für die Hülle.
Die Einstellung der jeweiligen Glasübergangstemperatur ist aufgrund des allgemeinen Fachwissens auf diesem Gebiet ohne weiteres durch Auswahl von geeigneten Monomeren oder Comonomeren und ihres Verhältnisses zueinander möglich. Die erfindungsgemäßen core/shell-Polymere werden im Rahmen der vorliegenden Erfindung als alleiniges Bindemittel verwendet. Aber auch Mischungen mit weiteren core/shell-Polymeren oder mit anderen üblichen Bindemitteln sind möglich, falls besondere Anforderungen an die Produkteigenschaften dies erfordern sollten.

Als Kernpolymere sind Homo- oder Copolymere geeignet, die aus den folgenden Monomeren und Comonomeren bestehen:

Methylmethacrylat, Ethylmethacrylat, Isopropylmethacrylat, Butylacrylat, 2-tert.-Butylphenylacrylat, 4-tert.-Butylphenylacrylat, 4-Cyanophenylacrylat, Phenylacrylat, Benzylmethacrylat, 2-Chloroethylmethacrylat, Butylmethacrylat, 2-Cyanoethylmethacrylat, Cyclohexylmethacrylat, 2-Hydroxyethylmethacrylat, 2-Hydroxypropylmethacrylat, Phenylmethacrylat, Acrylsäure, Methacrylsäure, Acrylamid, Methacrylamid, Acrylnitril, Styrol, Vinylverbindungen wie Vinylester und Vinylchlorid, Vinylidenchlorid, Butadien u. a.

Geeignete Homo- oder Copolymere als Hüllenpolymere können aus den für den Kern angegebenen Monomeren bzw. Comonomeren aufgebaut sein und auch aus einer Vielzahl weiterer Monomere. Genannt seien vor allem: Methylacrylat, Ethylacrylat, Hydroxyethylacrylat, Propylacrylat, n-Butylacrylat, 2-Ethylhexylacrylat, Benzylacrylat, Cyanobutylacrylat, Cyanoethylacrylat, Cyclohexylacrylat, Pentylacrylate, Hexylacrylate, Acrylester Copolymere mit Acrylnitril, n-Butylmethacrylat, Pentylmethacrylat und Hexylmethacrylat.

Zur Bildaufzeichnung geeignete feinteilige Pulver sind aus der Literatur, beispielsweise aus der DE-PS 19 04 059 und der DE-PS 29 46 896, in grosser Zahl bekannt. Bei diesen Pulvern handelt es sich überwiegend um Pigmente, jedoch sind auch gelöste Farbstoffe brauchbar. Als Beispiele seien genannt anorganische und organische Pigmente, Leuchtstoffe, Metallpulver in reiner Form oder zusammen mit einem pulverförmigen organischen oder anorganischen Träger, wie Titandioxyd, SiO₂, Glaspulver, Kohlenstoff (Ruß oder Graphit), Metall-Phthalocyanine, Azofarbstoffe, Metallpulver aus Aluminium, Kupfer, Eisen, Gold oder Silber oder Metalloxyde und lösliche organische Farbstoffe. Die Herstellung der Beschichtungsmasse erfolgt nach bekannten Methoden. Nach einer bevorzugten Ausführungsform wird die Latexmasse des core/ shell-Polymeren mit dem in an sich bekannter Weise vordispergierten feinteiligen Pulver vermischt.

Die einzelnen Herstellungsmöglichkeiten werden in den nachfolgenden Beispielen veranschaulicht.

Zur Herstellung der Übertragungsschicht wird die Beschichtungsmasse nach bekannten Methoden auf einen geeigneten Schichtträger aufgetragen und anschliessend getrocknet.
Geeignete Schichtträger sind insbesondere Kunststoffolien aus Polyestern, Polyamiden, Polyethylen, Polypropylen, Polyvinylchlorid u. dgl.
Die Dicke der getrockneten Schicht beträgt weniger als 5 µm, bevorzugt weniger als 2 µm. Die besonders bevorzugte Ausführungsform mit einer Polypropylenschaumfolie gemäß DE-OS 37 06 528 und einer Schichtdicke von 1 µm ist in Beispiel 6 beschrieben.
Ausser den bereits genannten Bestandteilen kann die Beschichtungsmasse noch andere Zusätze, wie Netzmittel, Giesshilfsmittel, Mittel zur Erhöhung der Viskosität, Haftverbesserungsmittel und dergleichen enthalten.
Besonders bewährt im Rahmen der vorliegenden Erfindung hat sich die Verwendung fluorierter Netzmittel, sowie die Verwendung von Polyethylenoxyden mit hohem Molekulargewicht zur Steigerung der Viskosität der Beschichtungsmasse.

Das vorliegende Verfahren eignet sich zur Bilderzeugung auf allen lichtempfindlichen Schichten, die durch bildmässige Belichtung in klebrige und nicht-klebrige Bereiche modifizierbar sind. Die lichtempfindliche Schicht kann sowohl aus positiv als auch negativ tonbaren Systemen bestehen.
Als positiv tonbare Systeme sind photohärtbare, vor allem jedoch die photopolymerisierbaren Systeme geeignet, wie sie in den deutschen Patentschriften 12 10 321, 19 04 058, 19 04 059 und 20 04 214 beschrieben sind. Diese photopolymerisierbaren Systeme enthalten als wesentliche Bestandteile ein oder mehrere additionspolymerisierbare Monomere, ein Bindemittel oder ein Bindemittelgemisch und einen Photoinitiator bzw. ein Initiatorsystem.
Negativ tonbare Systeme sind ebenfalls bekannt und beispielsweise in den Deutschen Patentschriften 27 58 209, 30 23 247 und 34 29 615 beschrieben. Diese Systeme enthalten als lichtempfindliche Komponenten entweder eine lichtempfindliche Dihydropyridinverbindung oder ein lichtempfindliches System bestehend aus einer Dihydropyridinverbindung und einer Hexaarylbisimidazolverbindung.

Die lichtempfindlichen Materialien besitzen ihre maximale Empfindlichkeit im Ultraviolettbereich, bevorzugt im Wellenlängenbereich zwischen 250 und 450 nm. Zur Belichtung sind daher alle Strahlungsquellen geeignet, die eine wirksame Menge dieser Strahlung liefern, beispielsweise Xenonlampen, Quecksilberdampflampen und Kohlebogenlampen, Laser, Fluoreszenzlampen mit UV-Strahlung emittierenden Leuchtstoffen und Elektronenblitzgeräte.

Das erfindungsgemässe Verfahren kann mit Vorteil zur Wiedergabe von Strich- und Rasteraufnahmen für die Anwendung im graphischen und sonstigen industriellen Bereichen, zur Herstellung von Landkarten Werbedrucken, Plakaten, Leuchtschriften und zur Herstellung gedruckter Schaltungen verwendet werden.
Das Hauptanwendungsgebiet liegt jedoch in der Herstellung von Ein- oder Mehrfarbenbildern und in der Verwendung für Farbprüfverfahren.

Die Durchführung eines Farbprüfverfahrens gemäß der vorliegenden Erfindung umfaßt die folgenden Verfahrensschritte:

Das lichtempfindliche Material z. B. ein Laminat aus einer auf eine Trägerfolie aufgetragenen photopolymerisierbaren Schicht mit einer Deckfolie wird nach Entfernung der Deckfolie auf ein Bildempfangsmaterial aufgebracht und durch den transparenten Schichtträger hindurch, je nach dem ob es sich um ein positiv oder negativ arbeitendes System handelt, unter Verwendung eines gerasterten Farbauszugs-Positivs oder -Negativs einer ersten Farbe als Vorlage mit aktinischer Strahlung zur Ausbildung von klebrigen und nicht klebrigen Bereichen belichtet und die Übertragungsschicht auf die belichtete Schicht auflaminiert und wieder abgezogen. Man erhält ein gefärbtes Bild der Vorlage. Ein zweites Laminat des lichtempfindlichen Materials wird nach Entfernung der Deckfolie auf das Bild auflaminiert und unter gleichen Bedingungen durch ein gerastertes Farbauszugs-Negativ oder -Positiv einer zweiten Farbe als Vorlage belichtet und durch Auflaminieren und wieder Abziehen der Übertragungsschicht getont.

Dieser Vorgang wird dann für einen Farbauszug einer dritten Farbe und falls erwünscht, für einen Schwarzauszug wiederholt. Man erhält ein den Vorlagen entsprechendes vierfarbiges Bild.

Ein besonderer Vorteil des erfindungsgemäßen Verfahrens besteht darin, daß man, ausgehend von einem positiv arbeitenden lichtempfindlichen System, auch mit negativen Farbauszügen als Vorlage 4-farbige Overlays und daraus einen positiven Farbprüfdruck herstellen kann.

Wird von negativen Farbauszügen ausgegangen, so wird zunächst ein Prüfdruck nach der oben angegebenen Verfahrensweise hergestellt. Die auf den für die Übertragung der Teilfarben verwendeten Übertragungsschichten verbleibenden Restbilder werden dann zur Herstellung des Prüfdruckes unter Verwendung von klebenden Zwischenschichten, unter Anwendung von Druck und/oder Wärme und nachfolgendem Abzug des Schichtträgers übereinander laminiert.
Nach einer anderen Ausführungsform ist es jedoch auch möglich, die auf den Übertragungsschichten verbleibenden Restbilder als Overlay übereinander zu legen.
Im Vergleich mit den Übertragungsmaterialien der DE-PS 36 25 014 sind die erfindungsgemäßen Übertragungsschichten wesentlich zeit- und kostengünstiger und mit gleichbleibender Qualität herstellbar, wobei zudem ein einheitlicherer Auftrag und eine Farbschicht mit geringeren Dichteschwankungen erhalten wird. Dadurch wird eine fehlerfreie übertragung und eine hohe Auflösung erzielt. Durch den Einsatz der erfindungsgemäßen Polymere werden pigmentierte Schichtübertragungsmaterialien mit kontrollierbarem Aufbau erhalten.

Die nachfolgenden Beispiele sollen die Erfindung veranschaulichen. Folgende Abkürzungen werden hierbei vewendet:
MMA für Methylmethacrylat, MAA für Methacrylsäure, EA für Ethylacrylat, 2EHMA für 2-Ethylhexylmethacrylat, AllylMA für Allylmethacrylat und BuMA für Butylmethacrylat.

### Beispel 1 Herstellung der core/shell-Polymere

Zur Herstellung des Polymers A (Tabelle 1) werden unter Rühren zu einer auf 80 - 85° C erwärmten Lösung A aus 9,4 g 30%iger wäßrige Natriumlaurylsulfatlösung und 1045 g deionisiertem Wasser nacheinander 1/8 einer Monomermischung 1 aus 324,5 g MMA, 17,5 g AllylMA und 7 g MAA, 4,75 g einer 5%igen wäßrigen Ammoniumpersulfatlösung (Lösung B) und innerhalb von 90 min die restliche Monomermischung 1 gegeben.

Das Reaktionsgemisch wird noch 2,5 h auf 80 - 85° C erwärmt, dann auf 40 - 50° C abgekühlt und innerhalb von 30 min eine Lösung C aus 10 g 30%iger wäßriger Natriumlaurylsulfatlösung, 3,3 g 5%iger wäßriger Ammoniumpersulfatlösung und 1021 g deionisiertem Wasser zugegeben. Anschließend wird wieder auf 80 - 85° C erwärmt und eine Monomermischung 2 aus 181,3 g EA, 160,4 g MMA und 7 g MAA innerhalb von 60 min zugegeben. Nach 2 h Erwärmen der Reaktionsmischung auf 85 - 90° C wird auf Raumtemperatur abgekühlt und das Polymer abfiltriert, gewaschen und getrocknet.
Die Polymere B - E (Tabelle 1) werden analog Polymer A hergestellt, wobei die folgenden Lösungen verwendet werden:

### a) Polymer B

| | |
|---|---|
| Monomermischung 1 | 649 g MMA, 35 g AllylMA, 14 g MAA |
| Monomermischung 2 | 24,4 g 2EHMA, 10,6 g EA |
| Lösung A | 2090 g Wasser, 18,8 g 30%ige Natriumlaurylsulfatlösung |
| Lösung B | 9,5 g 5%ige Ammoniumpersulfatlösung |
| Lösung C | 1 g 30%ige Natriumlaurylsulfatlösung, 0,35 g 5% Ammoniumpersulfatlösung, 115 g Wasser |

### b) Polymer C

| | |
|---|---|
| Monomermischung 1 | 324,5 g MMA, 17,5 g AllylMA, 7 g MAA |
| Monomermischung 2 | 146,5 g BuMA, 195,3 g EA, 7 g MAA |
| Lösung A | 1045 g Wasser, 9,4 g 30%ige Natriumlaurylsulfatlösung |
| Lösung B | 4,75 g 5%ige Ammoniumpersulfatlösung |
| Lösung C | 10 g 30%ige Natriumlaurylsulfatlösung, 3,3 g 5% Ammoniumpersulfatlösung, 1021 g Wasser |

### c) Polymer D

| | |
|---|---|
| Monomermischung 1 | 324,5 g MMA, 17,5 g AllylMA, 7 g MAA |
| Monomermischung 2 | 236 g 2EHMA, 105,6 g EA, 7 g MAA |
| Lösung A | 1045 g Wasser, 9,4 g 30%ige Natriumlaurylsulfatlösung |
| Lösung B | 4,75 g 5%ige Ammoniumpersulfatlösung |
| Lösung C | 10 g 30%ige Natriumlaurylsulfatlösung, 3,3 g 5% Ammoniumpersulfatlösung, 1021 g Wasser |

### e) Polymer E

| | |
|---|---|
| Monomermischung 1 | 1460,25 g MMA, 78,75 g AllylMA, 31,5 g MAA |
| Monomermischung 2 | 159,98 g 2EHMA, 71,55 g EA, 4,73 g MAA |
| Lösung A | 4702 g Wasser, 42,3 g 30%ige Natriumlaurylsulfatlösung |
| Lösung B | 21,4 g 5%ige Ammoniumpersulfatlösung |
| Lösung C | 6,75 g 30%ige Natriumlaurylsulfatlösung, 2,25 g 5% Ammoniumpersulfatlösung, 776 g Wasser |

**Tabelle 1**

| Polymer | | % | Monomere | %-Monomere | Tg |
|---|---|---|---|---|---|
| A | core | 50 | MMA/AllylMA/MAA | 93/5/2 | + 102° C |
| | shell | 50 | EA/MMA/MAA | 52/46/2 | + 40° C |
| B | core | 95 | MMA/AllylMA/MAA | 93/5/2 | + 102° C |
| | shell | 5 | 2EHMA/EA | 70/30 | - 15° C |
| C | core | 50 | MMA/AllylMA/MAA | 93/5/2 | + 102° C |
| | shell | 50 | BuMA/EA/MAA | 42/56/2 | 0° C |
| D | core | 50 | MMA/AllylMA/MAA | 93/5/2 | + 102° C |
| | shell | 50 | 2EHMA/EA/MAA | 68/30/2 | - 15° C |
| E | core | 87 | MMA/AllylMA/MAA | 93/5/2 | + 102° C |
| | shell | 13 | 2EHMA/EA/MAA | 68/30/2 | - 15° C |

### Beispiel 2

Zur Herstellung einer erfindungsgemäßen übertragungsschicht wird eine Beschichtungsmasse folgender Zusammensetzung hergestellt:
Zu 41.7 g des 24.5 Gew.-%igen Latex des core/shell-Polymers A werden unter Rühren 4.9 g einer Dispersion eines feinteiligen Cyan-Pigments langsam zugegeben.

Zur Herstellung der Pigment-Dispersion werden folgende Bestandteile

| | |
|---|---|
| 80.2 g | deionisiertes Wasser |
| 3.9 g | Natriumlaurylsulfat |
| 10.9 g | ethoxyyliertes Octylphenol |
| 9.3 g | eines mit Alkali neutralisierten Copolymerisates aus Acrylsäure und einem Acrylat-Comonomeren als Dispergiermittel |
| 45.0 g | Cyan-Pigment auf Kupferphthalocyaninbasis (C.I. 74160) |

in einer handelsüblichen Dispergiermühle 1 Stunde mit 5 000 UpM gemahlen.
Der Beschichtungsmasse wird dann eine ein viskositätserhöhendes Mittel, sowie Netz- und Gießhilfsmittel enthaltende Lösung folgender Zusammensetzung:

| | |
|---|---|
| 39.8 g | deionisiertes Wasser |
| 12.1 g | einer 2.25 Gew.-%igen Lösung von Polyethylenoxid, mittleres MG 2 000 000 |
| 1.2 g | anionisches Fluornetzmittel |
| 6.3 g | eines zweiten anionischen Fluornetzmittels |

unter Rühren zugegeben.

Die Beschichtungsmasse wird dann so auf eine Polyethylenterephthalat-Folie (25 um) aufgetragen, daß nach dem Trocknen eine 1 um dicke Schicht erhalten wird mit fehlerfreier Oberfläche ohne Dichteschwankungen.

Zur Herstellung der Farbbilder wird dann die übertragunsschicht auf ein gemäß den Angaben von Beispiel 1 der US-PS 4,356,253 hergestellte positiv tonbare photopolymerisierbare Schicht - gegebenenfalls nach Entfernung der Deckfolie - auf ein Bildempfangsmaterial auflaminiert und durch einen gerasterten positiven Cyan-Farbauszug in einem Vakuumkopierrahmen mit einer Metallhalogenidlampe (3000 Watt) unter Verwendung eines Ultraviolett-Filters 42 s im Abstand von 95 cm belichtet.

Nach Entfernung des Schichtträgers wird die das Tonermaterial enthaltende übertragungsschicht auf die bildmäßig belichtete Schicht auflaminiert und sofort wieder abgezogen. Die übertragungsschicht bleibt nur auf den unbelichteten, klebrigen Stellen haften, und man erhält ein positives Cyanbild der Vorlage mit einer Auflösung von 2% - 98% Punkten im 60-Linien/cm Raster.

### Beispiel 3

Es wird eine übertragungsschicht aus den folgenden Bestandteilen hergestellt:

41.7 g des 24.5 Gew.-%igen Latex des core/shell-Polymers B werden vorgelegt.

Anschließend werden 4.9 g einer gemäß den Angaben von Beispiel 2 hergestellten Pigmentdispersion unter Rühren zugegeben.

Der Beschichtungsmasse wird dann noch eine Lösung aus

| | |
|---|---|
| 12.1 g | einer 2.25 Gew.-%igen Lösung Polyethylenoxid mittleres MG 2 000 000 |
| 40.6 g | deionisiertem Wasser und |
| 1.5 g | anionischen Fluornetzmitteln |

unter Rühren zugegeben.

Die Beschichtungsmasse wird dann so auf eine Polyethylenterephthalat-Folie (25 um) aufgetragen, daß nach dem Trocknen eine 1 um dicke Schicht erhalten wird mit fehlerfreier Oberfläche ohne Dichteschwankungen.

Zur Herstellung der Farbbilder wird dann die übertragungsschicht auf ein gemäß den Angaben von Beispiel 2 hergestelltes und belichtetes Material auflaminiert und wieder abgezogen. Die gefärbte übertragungsschicht bleibt nur auf den unbelichteten, klebrigen Stellen haften und man erhält ein positives Cyanbild der Vorlage mit einer Auflösung von 2 % - 98 % Punkten im 60 Linien/cm Raster.

### Beispiel 4

Es wird eine übertragungsschicht aus den folgenden Bestandteilen hergestellt:

Zu 41.7 g des 24.5 Gew.-%igen Latex des core/shell-Polymers C werden 4.9 g einer gemäß den Angaben von Beispiel 2 hergestellten Pigment-dispersion unter Rühren zugegeben.

Der Beschichtungsmasse wird dann noch eine Lösung aus

| | |
|---|---|
| 12.1 g | 2.25 Gew.-%igem Polyethylenoxid MG 2 000 000 |
| 39.8 g | deionisiertem Wasser und |
| 1.5 g | anionischen Fluornetzmitteln |

unter Rühren zugegeben.

Die Beschichtungsmasse wird dann so auf eine Polyethylenterephthalat-Folie (25 um) aufgetragen, daß nach dem Trocknen eine 1 µm dicke Schicht erhalten wird.
Zur Herstellung der Farbbilder wird dann die übertragungsschicht auf ein gemäß den Angaben von Beispiel 2 hergestelltes und belichtetes Material auflaminiert und wieder abgezogen.
Es wird kein gerastertes Bild erhalten. Die Schicht verbleibt an Unterlage. Die Adhäsion zur Unterlage und die Kohäsion innerhalb der Schicht ist zu hoch.

### Beispiel 5

Es wird eine übertragungsschicht aus den folgenden Bestandteilen hergestellt:

Zu 41.7 g des 24.5 Gew.-%igen Latex des core/shell-Polymers D werden 4.9 g einer gemäß den Angaben von Beispiel 2 hergestellten Pigment-dispersion ebenfalls unter Rühren zugegeben.

Der Beschichtungsmasse wird dann noch eine Lösung aus

| | |
|---|---|
| 12.1 g | 2.25 Gew.-%igem Polyethylenoxid MG 2 000 000 |
| 39.8 g | deionisiertem Wasser und |
| 1.5 g | anionischen Fluornetzmitteln |

unter Rühren zugegeben.

Die Beschichtungsmasse wird dann so auf eine Polyethylenterephthalat-Folie (25 um) aufgetragen, daß nach dem Trocknen eine 1 um dicke Schicht erhalten wird.

Zur Herstellung der Farbbilder wird dann die übertragungsschicht auf ein gemäß den Angaben von Beispiel 2 hergestelltes und belichtetes Material auflaminiert und wieder abgezogen.

Das Ergebnis ist kein gerastertes Bild. Die beschichtete Massse verbleibt auf der Unterlage.

### Beispiel 6

Es wird eine übertragungsschicht aus folgenden Bestandteilen hergestellt:

Zu 8,894 g des 24.5 Gew.-%igen Latex des core/shell-Polymers E werden unter Rühren 7.228 g einer Dispersion eines feinverteilten Cyanpigments langsam zugegeben. Anschließend wird noch folgende Mischung eingerührt:

| | |
|---|---|
| 9.447 g | Wasser |
| 1.920 g | einer 2.25 Gew.-%igen Lösung von Polyethylenoxid, mittleres MG 100 000 |
| 1.920 g | einer 2.25 Gew.-%igen Lösung von Polyethylenoxid, mittleres MG 2 000 000 |
| 414 g | eines Fluornetzmittels und |
| 103 g | eines zweiten Fluornetzmittels. |

Die Beschichtungsmasse wird mit einem 70 Linien/cm Linienraster bei 20 m/min im reversiblen Gravurdruck auf eine 60 um dicke Polypropylenschaumfolie gemäß DE-OS 37 06 528 so aufgedruckt, daß nach dem Trocknen eine ca. 0.4 um dicke Schicht erhalten wird mit fehlerfreier Oberfläche ohne Dichteschwankungen.

Die Folie hat eine A-B-A Struktur, wobei der B-Kern aus ca. 58 um Schaumpolypropylen besteht und die A-Schichten jeweils aus ca. 1 um dicken Polypropylencopolymeren bestehen und der gesamten Folie eine glatte Oberfläche geben. Die eine A-Seite ist durch Coronabehandlung polar auf ca. 36 dyn/cm gebracht worden. Auf diese Seite wird die Beschichtungsmasse aufgedruckt.

Zur Herstellung der Farbbilder wird dann die übertragungsschicht auf ein gemäß den Angaben von Beispiel 2 hergestelltes und belichtetes Material auflaminiert und wieder abgezogen. Die gefärbte übertragungsschicht bleibt nur auf den unbelichteten, klebrigen Stellen haften, und man erhält ein positives Cyanbild der Vorlage mit einer Auflösung von 2% - 98X Punkten im 60-Linien/cm Raster.

### Beispiel 7

Es wird eine übertragungsschicht aus den folgenden Bestandteilen hergestellt:

Zu 41.7 g des 24.5 Gew.-%igen Latex des core/shell-Polymers E werden 4.9 g einer gemäß den Angaben von Beispiel 2 hergestellten Pigment-dispersion ebenfalls unter Rühren zugefügt.

In die Beschichtungsmasse wird dann eine Lösung aus folgenden Bestandteilen:

| | |
|---|---|
| 12.1 g | 2.25 Gew.-%iges Polyethylenoxid MG 2 000 000 |
| 1.5 g | anionische Fluornetzmittel |
| 39.8 g | deionisiertes Wasser |

zugegeben.

Nach guter Homogenisierung wird die Beschichtungsmasse dann so auf eine Polyethylenterephthalat-Folie (25 um) aufgetragen, daß nach dem Trocknen eine 1 um dicke Schicht erhalten wird mit fehlerfreier Oberfläche ohne Dichteschwankungen.

Zur Herstellung des Farbbildes wird dann die übertragungsschicht auf ein gemäß den Angaben von Beispiel 2 hergestelltes und belichtetes Material auflaminiert und wieder abgezogen. Die gefärbte übertragungsschicht bleibt nur auf den unbelichteten, klebrigen Stellen haften und man erhält ein positives Cyanbild der Vorlage mit einer Auflösung von 2 % - 98 % Punkten im 60 Linien/cm Raster.

### Beipiel 8

Zur Herstellung eines Vierfarbenbildes werden 4 übertragungschichten der Farben Cyan, Magenta, Gelb und Schwarz wie folgt hergestellt:

Zu 500.4 g des 24.5 Gew.-%igen Latex des core/shell-Polymers E werden folgende Komponenten unter Rühren hinzugefügt:

| | |
|---|---|
| 145,2 g | 2.25 Gew.-%igem Polyethylenoxid MG 2 000 000 |
| 441.6 g | deionisiertem Wasser und |
| 14.4 g | anionisches Fluornetzmittel #1 und |
| 3.6 g | anionisches Fluornetzmittel #2. |

Die Beschichtungsmasse wird dann in 4 Teile a)-d) geteilt und den einzelnen Proben die in Tabelle 1 angegebenen Zusätze zugefügt.

**Tabelle 1**

| (alle Angaben in g) | | | | |
|---|---|---|---|---|
| Zusätze | Probe a) Cyan | Probe b) Magenta | Probe c) Gelb | Probe d) Schwarz |
| Gemäß Beispiel 1 vorbehandelte Farbpigment-Dispersion | 23.7 | 23.7 | 23.7 | 23.7 |

Die Farbpigmente werden gemäß den Angaben von Beispiel 1 gemahlen.

Als Pigmente werden für die Cyan-übertragungsschicht eine Mischung eines Cyan-Pigments auf Kupferphthalocyanbasis (C.I.74160) und eines Magenta-Pigments (C.I. Pigment Red 123), für die Magentaübertragungsschicht ein Gemisch zweier Magenta-Pigmente (C.I. Pigment Red 122 und Pigment Red 123) und für die Gelbübertragungsschicht das Farbpigment C.I. Pigment Yellow 17 verwendet. Die übertragungsschicht für Schwarz enthält C.I. Pigment Black 7.

Nach guter Homogenisierung werden die Beschichtungsmassen a)-d) dann so auf eine Polyethylenterephthalat-Folie (25 um) aufgetragen, daß nach dem Trocknen jeweils eine 1 um dicke gefärbte Schicht erhalten wird mit fehlerfreier Oberfläche ohne Dichteschwankungen.

Die Farbdichte der einzelnen Schichten beträgt:

| | |
|---|---|
| Cyan | 1.39 |
| Magenta | 1.40 |
| Gelb | 1.30 |
| Schwarz | 1.80 |

Zur Herstellung eines Vierfarben-Prüfdruckes wird eine gemäß den Angaben von Beispiel 1 der US-PS 4,356,253 hergestellte positiv tonbare photopolymerisierbare Schicht - gegebenenfalls nach Entfernung der Deckfolie - auf ein Bildempfangsmaterial auflaminiert und durch einen gerasterten positiven Cyan-Farbauszug in einem Vakuumkopierrahmen mit einer Metallhalogenidlampe (3000 Watt) unter Verwendung eines Ultraviolett-Filters 42 s im Abstand von 95 cm belichtet. Nach Entfernung des Schichtträgers wird die das Pigmentmaterial enthaltende Übertragungsschicht a) auf die bildmäßig belichtete Schicht auflaminiert und sofort wieder abgezogen. Die übertragungsschicht bleibt nur auf den unbelichteten, klebrigen Stellen haften und man erhält ein positives Cyanbild der Vorlage.

Eine zweite Schicht des positiv tonbaren photopolymerisierbaren Aufzeichnungsmaterials wird auf das Cyanbild auflaminiert und wie oben durch den entsprechenden gerasterten Magenta-Farbauszug belichtet. Nach Entfernung des Schichtträgers wird die das Pigmentmaterial enthaltende Übertragungsschicht b) auf die bildmäßig belichtete Schicht auflaminiert und wieder abgezogen. Die Übertragungsschicht bleibt nur an den unbelichteten klebrigen Stellen haften, und man erhält ein positives Magenta-Bild. Für die Farben Gelb und Schwarz werden die Arbeitsschritte entsprechend wiederholt und anschließend in üblicher Weise eine Schutzschicht aufgebracht. Man erhält einen Vierfarben-Prüfdruck von ausgezeichneter Brillianz und Schärfe mit einer Auflösung von 2% - 98% im 60-Linien/cm Raster, der eine naturgetreue Wiedergabe des Originals darstellt.

## Patentansprüche

1. Verfahren zur Herstellung von Bildern bei dem
A) auf einer lichtempfindlichen Schicht durch bildmäßige Belichtung klebrige und nicht-klebrige Bereiche erzeugt werden,
B) die belichtete Schicht mit einer auf einem Schichtträger befindlichen Übertragungsschicht, die nicht lichtempfindlich ist und mindestens ein feinteiliges Pulver und/oder einen gelösten Farbstoff in ihrem Bindemittel enthält, in Kontakt gebracht wird, und
C) die beiden Schichten getrennt werden,
dadurch gekennzeichnet, daß
das Bindemittel der übertragungsschicht mindestens ein core/shell-Polymer, bestehend aus einen Kern und eine Hülle aufweisenden Teilchen, enthält, wobei
a) der Kern 5 - 95 Gew.-% eines Teilchens ausmacht und aus einem Polymer mit einer Glasübergangstemperatur von über 50° C besteht und
b) die Hülle 5 - 95 Gew.-% eines Teilchens ausmacht und aus einem Polymer mit einer Glasübergangstemperatur von unter 40° C besteht.

2. Verfahren nach Anspruch 1,
dadurch gekennzeichnet, daß
ein core/shell-Polymer verwendet wird, mit 5 - 50 Gew.-% einer Hülle aus einem Polymer mit einer Glasübergangstemperatur unter 20° C.

3. Verfahren nach Anspruch 1,
dadurch gekennzeichnet, daß
ein core/shell-Polymer verwendet wird, mit 5 - 15 Gew.-% einer Hülle aus einem Polymer mit einer Glasübergangstemperatur unter 0° C.

4. Verfahren nach Anspruch 1,
dadurch gekennzeichnet, daß
ein core/shell-Polymer verwendet wird, mit 50 - 95 Gew.-% einer Hülle aus einem Polymer mit einer Glasübergangstemperatur zwischen 20° C und 40° C.

5. Verfahren nach Anspruch 1
dadurch gekennzeichnet, daß
der Kern des verwendeten core/shell-Polymeren 40 - 95 Gew.% eines Teilchens ausmacht.

6. Verfahren nach Anspruch 1,
dadurch gekennzeichnet, daß
ein core/shell-Polymer verwendet wird, das einen Kern aufweist aus einem Polymer mit einer Glasübergangstemperatur von >90° C.

7. Verfahren nach Anspruch 1,
dadurch gekennzeichnet, daß
als tonbare lichtempfindliche Schicht eine photopolymerisierbare Schicht verwendet wird, die mindestens ein photopolymerisierbares Monomeres, einen Photoinitiator bzw. Initiatorsystem und ein Bindemittel bzw. Bindemittelgemisch enthält.

8. Verfahren zur Herstellung von Mehrfarbenbildern bei dem
A) auf einen Bildträger eine lichtempfindliche Schicht aufgebracht wird, in der durch bildmäßige Belichtung klebrige und nicht-klebrige Bereiche erzeugt werden können,
B) bildmäßig belichtet,
C) die belichtete Schicht mit einer auf einem Schichtträger befindlichen Übertragungsschicht, die nicht lichtempfindlich ist und ein feinteiliges Pigment enthält, in Kontakt gebracht wird,
D) der Schichtträger mit den nicht haftenden Bereichen der Übertragungsschicht wieder entfernt wird,
E) auf das entstandene Bild eine neue lichtempfindliche Schicht aufgebracht wird, und
F) die Schritte B - E mehrfach wiederholt werden,
dadurch gekennzeichnet, daß
das Bindemittel der übertragungsschicht mindestens ein core/shell-Polymer, bestehend aus einen Kern und eine Hülle aufweisenden Teilchen, enthält, wobei
a) der Kern 5 - 95 Gew.-% der gesamten Teilchen ausmacht und aus einem Polymer mit einer Glasübergangstemperatur von über 50° C besteht und
b) die Hülle 5 - 95 Gew.-% der gesamten Teilchen ausmacht und aus einem Polymer mit einer Glasübergangstemperatur von unter 40° C besteht.

## Claims

1. Process for preparing images which comprises
A) forming tacky and non-tacky areas on a light-sensitive layer by imagewise exposure,
B) contacting the exposed layer with a transfer layer on a support, the transfer layer being non-lightsensitive and containing in its binder at least one finely divided powder and/or at least one dissolved dye,
C) separating these two layers,
characterized in that,
the binder of the transfer layer comprises at least one core/shell polymer consisting of particles having a core and a shell, wherein
a) the core forms 5 - 95 percent by weight of the total particle and consists of a polymer having a glass transition temperature above 50 °C, and
b) the shell forms 5 - 95 percent by weight of the total particle and consists of a polymer having a glass transition temperature below 40 °C.

2. A process according to claim 1,
characterized in that,
the core/shell polymer comprises 5 - 50 percent by weight of a shell consisting of a polymer having a glass transition temperature below 20 °C.

3. A process according to claim 1,
characterized in that,
the core/shell polymer comprises 5 - 15 percent by weight of a shell consisting of a polymer having a glass transition temperature below 0 °C.

4. A process according to claim 1,
characterized in that,
the core/shell polymer comprises 50 - 95 percent by weight of a shell consisting of a polymer having a glass transition temperature between 20 °C and 40 °C.

5. A process according to claim 1,
characterized in that,
the core of the core/shell polymer forms 40 - 95 percent by weight of a particle.

6. A process according to claim 1,
characterized in that,
the core of the the core/shell polymer consists of a polymer having a glass transition temperature > 90 °C.

7. A process according to claim 1,
characterized in that,
a photopolymerizable layer containing at least one photopolymerizable monomer, a photoinitiator or initiator system, and a binder or mixture of binders is used as light-sensitive layer.

8. A process for preparing multi-color images which comprises
A) applying a light-sensitive layer onto an image carrier, in which layer tacky and non-tacky areas can be formed by imagewise exposure,
B) imagewise exposing,
C) contacting the exposed layer with a transfer layer on a support, the transfer layer being non-lightsensitive and containing a finely divided pigment,
D) removing the support with the non-adhering areas of the transfer layer,
E) applying a new light-sensitive layer onto the formed image, and
F) repeating steps B - E sevearl times,
characterized in that,
the binder of the transfer layer comprises at least one core/shell polymer consisting of particles having a core and a shell, wherein
a) the core forms 5 - 95 percent by weight of the total particle and consists of a polymer having a glass transition temperature above 50 °C, and
b) the shell forms 5 - 95 percent by weight of the total particle and consists of a polymer having a glass transition temperature below 40 °C.

## Revendications

1. Procédé de fabrication d'images, dans lequel
A) on crée des régions adhérentes et non-adhérentes en exposant une couche photosensible avec transfert d'image,
B) on met la couche exposée au contact d'une couche de transfert, se trouvant sur un support de couche, laquelle n'est pas photosensible et contient au moins une poudre finement divisée et/ou un colorant dissous dans son liant, et
C) on sépare les deux couches,
caractérisé en ce que
le liant de la couche de transfert contient au moins un polymère noyau/enveloppe, consistant en particules qui présentent un noyau et une enveloppe, où
a) le noyau constitue 5 - 95% en poids d'une particule et consiste en un polymère ayant une température de transition vitreuse supérieure à 50°C et
b) l'enveloppe constitue 5 - 95% en poids d'une particule et consiste en un polymère ayant une température de transition vitreuse inférieure à 40°C.

2. Procédé selon la revendication 1, caractérisé en ce que l'on utilise un polymère noyau/enveloppe avec une enveloppe de 5 - 50% en poids d'un polymère ayant une température de transition vitreuse inférieure à 20°C.

3. Procédé selon la revendication 1, caractérisé en ce que l'on utilise un polymère noyau/enveloppe avec une enveloppe de 5 - 15% en poids d'un polymère ayant une température de transition vitreuse inférieure à 0°C.

4. Procédé selon la revendication 1, caractérisé en ce que l'on utilise un polymère noyau/enveloppe avec une enveloppe de 50 - 95% en poids d'un polymère ayant une température de transition vitreuse comprise entre 20°C et 40°C.

5. Procédé selon la revendication 1, caractérisé en ce que le noyau du polymère noyau/enveloppe utilisé constitue 40 - 95% en poids d'une particule.

6. Procédé selon la revendication 1, caractérisé en ce que l'on utilise un polymère noyau/enveloppe présentant un noyau d'un polymère ayant une température de transition vitreuse de > 90°C.

7. Procédé selon la revendication 1, caractérisé en ce que l'on utilise comme couche pigmentable photosensible une couche photopolymérisable contenant au moins un monomère photopolymérisable, un photoinitiateur ou un système initiateur et un liant ou un mélange de liants.

8. Procédé de fabrication d'images polychromes, dans lequel
A) on dépose, sur un support d'image, une couche photosensible, dans laquelle on peut créer des régions adhérentes et non-adhérentes par exposition avec transfert d'image,
B) on expose avec transfert d'image
C) on met la couche exposée au contact d'une couche de transfert se trouvant sur un support de couche, laquelle n'est pas photosensible et contient un pigment finement divisé,
D) on enlève de nouveau le support de couche avec les régions non-adhérantes de la couche de transfert,
E) on déposé une nouvelle couche photosensible sur l'image formée, et
F) on recommence les étapes B) - E),
caractérisé en ce que
le liant de la couche de transfert contient au moins un polymère noyau/enveloppe constitué de particules présentant un noyau et une enveloppe, où
a) le noyau constitue 5 - 95% en poids de la totalité des particules et consiste en un polymère ayant une température de transition vitreuse supérieure à 50°C et
b) l'enveloppe constitue 5 - 95% en poids de la totalité des particules et consiste en un polymère ayant une température de transition vitreuse inférieure à 40°C.
